# EUROPEAN PATENT APPLICATION

(11) **EP 4 057 477 A1**
(43) Date of publication of application: **14.09.2022**
(21) Application number: 22160290.7
(22) Date of filing: 04.03.2022
(51) Int. Cl.: H02J 7/00

(54) **CELL FAULT DETECTION IN BATTERIES WITH PARALLEL CELLS**

(30) Priority: 08.03.2021 US 202117195305
(71) Applicant: Google LLC, Mountain View, CA 94043 (US)
(72) Inventor: LIM, James Robert, Mountain View, 94043 (US); CHEN, Mike Jonathon, Mountain View, 94043 (US); JONES, Mitchel Aaron, Draper (US); SAPERSTEIN, William Alan, San Carlos, 94043 (US); WANG, David, San Jose (US)
(74) Representative: Maikowski & Ninnemann Patentanwälte Partnerschaft mbB

(57) **Abstract**

Techniques to detect faults in a battery with at least two parallel battery cells. In some examples, a cell may fail or become disconnected. The circuitry of this disclosure may determine whether a battery pack has a fault by measuring battery parameters at the positive and negative terminals. When the circuitry detects a fault, the circuitry may adjust the charge rate so that the charge does not exceed the maximum charge rate of any single cell of the battery pack. In some examples, the circuitry may shut off the charge current to the battery pack to ensure that the charge rate does not exceed the maximum charge rate of any single cell. To avoid false positive fault detection, the circuitry of this disclosure may verify the detected fault and the parameters of the charging cycle before reducing the charging current.

## Description

### BACKGROUND

Battery packs may be arranged in various configurations, including battery cells in series, battery cells in parallel, and combinations of series and parallel. Battery cells in parallel may increase capacity, e.g., more amp-hours (A-hrs or Ah), while battery cells in series may increase the battery pack voltage. Some example configurations include 1S2P, which is one battery cell in series, i.e., a single battery cell between the positive and negative terminals of the battery pack with two battery cells in parallel. A 1S2P battery pack has the voltage of a single cell with the A-hr capacity of two battery cells. A 2S2P battery pack has two sets of two battery cells in series, with each of the two sets consisting of two cells wired in parallel. A 2S2P battery pack has four cells in total with double the voltage of a single cell, and four times the capacity of a single cell. In some examples, battery packs may be rechargeable.

### SUMMARY

In general, the disclosure describes techniques to detect faults in a cell of battery packs with at least two parallel battery cells. In some examples, a battery cell of the parallel battery cells may fail or become disconnected. The circuitry of this disclosure may determine whether a battery pack has a fault by measuring battery parameters at the positive and negative terminals of the entire battery pack. When the circuitry detects a fault, the circuitry may ensure that the charge rate does not exceed the maximum charge rate of any single cell of the battery pack, for example, in the event that a single fault causes one or more of the other cells to become electrically disconnected. In some examples, the circuitry may shut off the charge current to the battery pack to ensure that the charge rate does not exceed the maximum charge rate of any single cell. To avoid false positive fault detection, the circuitry of this disclosure may verify the detected fault and the parameters of the charging cycle before reducing the charging current.

In one example, this disclosure describes a method comprising: receiving, by processing circuitry, an indication of whether a charging control circuit is connected to an external power source; responsive to determining the charging control circuit is connected to the external power source, initiating, by the processing circuitry, a charging cycle for a battery that includes at least two cells in parallel; determining whether a state of charge for the battery satisfies a threshold state of charge; determining whether a full charge capacity for the battery satisfies a threshold charge capacity; and responsive to determining that both the full charge capacity satisfies the threshold charge capacity and that state of charge of the battery satisfies the threshold state of charge: determining that a battery cell error occurred; and adjusting, by the processing circuitry, a charge rate for the battery such that the charge rate does not exceed a maximum charge rate of any single cell of the battery.

In another example, this disclosure describes a device comprising a rechargeable battery comprising at least two cells in parallel; battery management circuitry configured to control an electrical current flow of the battery; a memory; and processing circuitry operatively coupled to the memory and to the battery management circuitry, the processing circuitry configured to: receive, from the battery management circuitry, an indication that the battery management circuitry is connected to an external power source; responsive to receiving the indication that the battery management circuitry is connected to the external power source, cause the battery management circuit to initiate a charging cycle for the battery; determine whether a state of charge for the battery satisfies a threshold state of charge; determine whether a full charge capacity for the battery satisfies a threshold charge capacity; and responsive to determining that both the full charge capacity satisfies the threshold charge capacity and that state of charge of the battery satisfies the threshold state of charge: determine that a battery cell error occurred; and cause the battery management circuitry to adjust a charge rate for the battery such that the charge rate does not exceed a maximum charge rate of any single cell of the battery.

In another example, this disclosure describes a non-transitory computer-readable storage medium comprising instructions that, when executed, cause one or more processors of a computing device to: receive an indication of whether a charging control circuit is connected to an external power source; responsive to determining the charging control circuit is connected to the external power source, initiate a charging cycle for a battery wherein the battery includes at least two cells in parallel; determine whether a state of charge for the battery satisfies a threshold state of charge; determine whether a full charge capacity for the battery satisfies a threshold charge capacity; and responsive to determining that both the full charge capacity satisfies the threshold charge capacity and that state of charge of the battery satisfies the threshold state of charge: determine that a battery cell error occurred; and ensure that a charge rate for the battery does not exceed a maximum charge rate of any single cell of the battery.

The details of one or more examples of the disclosure are set forth in the accompanying drawings and the description below. Other features, objects, and advantages of the disclosure will be apparent from the description and drawings, and from the claims.

### BRIEF DESCRIPTION OF DRAWINGS

FIG. 1 is a block diagram illustrating an example system that includes a rechargeable battery pack and battery management circuitry configured to detect a battery fault according to one or more techniques of this disclosure.
FIG. 2 is a block diagram illustrating an example battery pack with a single cell in series and two cells in parallel.
FIG. 3 is a block diagram illustrating an example battery pack with a single cell in series and multiple cells in parallel.
FIG. 4 is a flowchart illustrating an example operation of the battery fault detection techniques of this disclosure.
FIG. 5 is a flow chart illustrating an example cycle usability check according to one or more techniques of this disclosure.
FIG. 6 is a flow chart illustrating an example cycle error check, according to one or more techniques of this disclosure.

### DETAILED DESCRIPTION

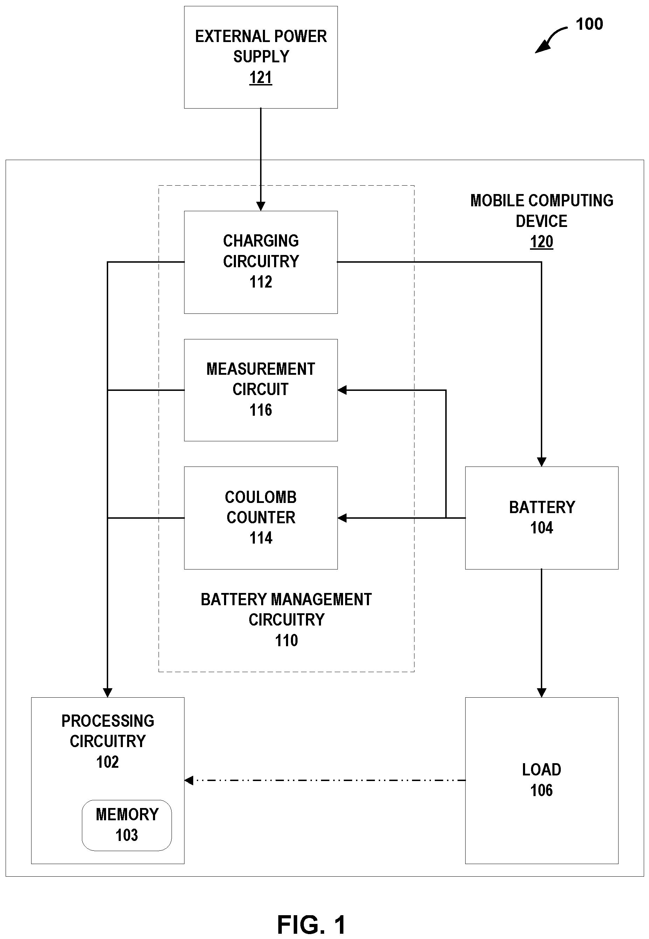

FIG. 1 is a block diagram illustrating an example system that includes a rechargeable battery pack and battery management circuitry configured to detect a battery fault according to one or more techniques of this disclosure. The example of mobile computing device 120 may include a mobile phone, tablet, wearable device such as fitness tracker or similar medical device, solar powered devices, such as fixed installation roadside monitoring devices, weather monitoring devices and similar devices that may receive power only during daylight. In this disclosure, a "battery pack" indicates a battery with at least two cells, but battery pack and battery may be used interchangeably.

The example of system 100 includes an external power supply 121, that provides power to mobile computing device 120. Mobile computing device 120 may include battery management circuitry 110, a battery 104 or other similar electrical energy storage device that provides electrical energy to load 106 and processing circuitry 102. In some examples, mobile computing device 120 may also include other components not shown in FIG. 1. For example, computing device 120 may include a user interface including input devices, such as a touch screen, buttons, switches etc., a display screen along with other indicators, such as LEDs, audio output devices, communication circuitry for wired and wireless communication, measurement circuits including sensors, amplifiers, filters, and other circuitry or components related to the functions of mobile computing device 120.

Processing circuitry 102 may receive signals and control the operation of components of mobile computing device 120. In some examples, processing circuitry 102 may be circuitry discrete from a central processing unit (CPU) or general purpose processor. In other examples, processing circuitry 102 may be part of the CPU/general purpose processor. Examples of processing circuitry 102 may include any one or more of a microcontroller (MCU), e.g. a computer on a single integrated circuit containing a processor core, memory, and programmable input/output peripherals, a microprocessor (µP), e.g. a CPU on a single integrated circuit (IC), a controller, a digital signal processor (DSP), an application specific integrated circuit (ASIC), a field-programmable gate array (FPGA), a system on chip (SoC) or equivalent discrete or integrated logic circuitry. A processor may be integrated circuitry, i.e., integrated processing circuitry, and that the integrated processing circuitry may be realized as fixed hardware processing circuitry, programmable processing circuitry and/or a combination of both fixed and programmable processing circuitry. Accordingly, the terms "processing circuitry," "processor" or "controller," as used herein, may refer to any one or more of the foregoing structures or any other structure operable to perform techniques described herein.

In the example of FIG. 1, memory 103 is integrated with processing circuitry 102. In other examples, memory 103 may include one or more components separate from processing circuitry 102 and communicatively coupled to processing circuitry 102. Examples of memory 103 may include any type of computer-readable storage media. include random access memory (RAM), read only memory (ROM), programmable read only memory (PROM), erasable programmable read only memory (EPROM), one-time programmable (OTP) memory, electronically erasable programmable read only memory (EEPROM), flash memory, or another type of volatile or non-volatile memory device. In some examples the computer readable storage media may store instructions that cause processing circuitry 102 to execute the functions described herein. In some examples, the computer readable storage media may store data, such as configuration information, temporary values and other types of data used to perform the functions of this disclosure.

Load 106 may include any components of mobile computing device 120 that may run on electrical energy. Some examples of components may include the user interface, sensors, such as accelerometers, amplifiers, integrated circuits as well as processing circuitry 102 and so on. In some examples, load 106 may include one or more additional processors (not shown in FIG. 1) that may communicate with processing circuitry 102, battery management circuitry 110, memory 103 or other computer readable storage components not shown in FIG. 1. In some examples, the additional processors may be a graphical processing unit (GPU) or other processor configured to perform specific tasks, but may also share some of the processing tasks of processing circuitry 102 as needed.

Battery management circuitry 110 may measure and regulate the flow of electrical energy to and from battery 104. In other words, battery management circuitry 110 may measure and control the electrical current flow for battery 104. In the example of FIG. 1, battery management circuitry 110 includes charging circuitry 112, coulomb counter 114, and measurement circuit 116. In other examples, battery management circuitry may include more or fewer components than shown in FIG. 1. Also, in other examples, the functions of components of battery management circuitry 110 may be arranged in a different manner than shown in FIG. 1. For example, the functions of measurement circuit 116 may be combined with the functions of coulomb counter 114. In some examples, battery management circuitry 110 may include processing circuitry and a memory configured to store computer readable instructions executable by the processing circuitry (not shown in FIG. 1). The processing circuitry of battery management circuitry 110 may communicate with, but be separate from, processing circuitry 102. In some examples, battery management circuitry 110 may be implemented as a single integrated circuit (IC). In other examples, battery management circuitry 110 may be implemented as separate components. Battery management circuitry 110 may be considered a "fuel gauge" circuit or "fuel gauge IC" for battery 104.

Charging circuitry 112 is a charging control circuit that may receive electrical power from external power supply 121. Charging circuitry 112 may set and regulate the charge rate, e.g., the magnitude of the charging current, to battery 104. In some examples, charging circuitry 112 may include sensors and safety mechanisms to protect against overvoltage, over current, over temperature and so on. Charging circuitry 112 may be communicatively coupled to processing circuitry 102. Charging circuitry 112 may detect when external power supply 121 is providing electrical power and provide an indication to processing circuitry 102 when charging circuitry 112 is connected to the external power source. In some examples, charging circuitry 112 may be preset or fabricated, e.g., hardwired based on the battery chemistry and arrangement of battery 104 to set and regulate the charge rate for battery 104. In other examples, charging circuitry 112 may receive commands from processing circuitry 102, or other components within battery management circuitry 110, to dynamically set and regulate the charge rate.

External power supply 121 is an external power source configured to supply electrical power to charging circuitry 112. Some examples of external power supply 121 may include an alternating current (AC) to direct current (DC) power supply, such as a switching power supply, or some similar AC to DC converter. In some examples, External power supply 121 may be configured to connect and detach from mobile computing device 120. In other examples, external power supply 121 may be a solar or wind powered electrical power source that only provides electricity when wind or light is available and may be configured to be always connected to mobile computing device 120.

Coulomb counter 114 may measure the amount of electrical energy flowing to and from battery 104. In the example of FIG. 1, coulomb counter 114 may measure the electrical energy from charging circuitry 112 to battery 104, as well as measure the electrical energy supplied by the battery to load 106. In this manner coulomb counter 114 may calculate the state of charge (SOC), or charge level, of battery 104. Coulomb counter 114 may also calculate a depth of discharge (DOD) of battery 104. In some examples, coulomb counter 114 may also determine a rate of change in SOC and DOD, e.g., a SOC rate or a DOD rate. The SOC rate, for example, may provide an indication of how fast the battery is charging or discharging.

Measurement circuit 116 may include temperature sensors, voltage sensors, current sensors and so on to measure the state of battery 104. Measuring the open circuit battery voltage may be another technique to determine the SOC of the battery. However, some battery chemistries may have a nearly flat discharge curve (voltage vs. SOC) over the operating capacity of the battery. In some examples of batteries, measuring the battery voltage may provide a more accurate indication of SOC for a battery that is nearly fully charged or close to fully discharged, where the discharge curve is steeper. Also, as temperature changes and as battery 104 ages, the discharge curve shape may change, and the amount of charge the battery may hold, e.g., the full charge capacity may change. Therefore, battery management circuitry 110 may use some combination of sensor measurements, e.g., voltage, temperature and so on, as well as information from coulomb counter 114 to determine battery status.

In some examples, battery management circuitry 110 may use some combination of sensor indications to determine full charge capacity, state of charge, and so on. Battery management circuitry 110 may determine whether a state of charge for the battery satisfies a threshold state of charge and determine whether a full charge capacity for the battery satisfies a threshold charge capacity. In other examples, battery management circuitry 110 may take measurements and communicate with processing circuitry 102, and processing circuitry 102, rather than any processing circuitry of battery management circuitry 110, may determine full charge capacity, SOC and other battery status values.

Similarly, in some examples, processing circuitry of battery management circuitry 110 may receive an indication when battery management circuitry 110 is connected to external power supply 121, or when external power supply 121 is providing power, such as in the case of a solar cell. Then, responsive to determining the battery management circuitry is connected to and receiving power from external power supply 121, the processing circuitry may cause battery management circuitry 110 to initiate a charging cycle for battery 104. In other examples, processing circuitry 102 may receive the indication that external power supply 121 is providing power and processing circuitry 102 may cause battery management circuitry 110 to initiate the charging cycle.

Battery 104 may provide electrical power to load 106 when not connected to external power supply 121. Battery 104 may be implemented as any type of rechargeable electrical energy storage device. The description of this disclosure will focus on a rechargeable battery pack with at least two parallel battery cells. However, the techniques of this disclosure may be beneficial to other types of electrical energy storage devices, such as multiple capacitor arrays. Battery 104 may include battery cells with a variety of battery chemistries, such as nickel-cadmium (NiCd), lithium-ion (Li-ion), nickel metal hydride (Ni-MH), lithium-ion polymer (LiPo), and so on. Each battery chemistry may have specific characteristics, such as a maximum and minimum usable voltage, the shape of the battery discharge curve, aging characteristics, reactions to changes in temperature, recovery voltage, storage capacity, maximum rated charging current and discharging current and so on.

In some examples, charge and discharge rates of a battery are governed by Crates. The capacity of a battery is commonly rated at 1C, meaning that a fully charged battery rated at 1Ah should provide 1A for one hour. The same battery discharging at 0.5C should provide 500mA for two hours, and at 2C the same battery may deliver 2A for thirty minutes. In the example of a two-cell battery arranged with parallel battery cells, e.g., a 1S2P battery pack, may have a battery capacity determined by the capacity of each cell. A 1S2P battery pack has single cells in series between the positive and negative terminals of the battery and two battery cells in parallel. For example, a 1S2P battery pack with two 3 Ah cells would have a total battery capacity of 6 Ah. The maximum rated charging current may be specified for each battery cell, for example, each cell may safely receive up to one amp, so the total rated charging current for the two-cell battery pack may be up to two amps. As noted above, charging circuitry 112 may control the charge rate.

In operation, the components of mobile computing device 120 may be configured to detect faults in a cell of battery packs with at least two parallel battery cells. In some examples, a battery cell of the parallel battery cells may fail or become disconnected. The circuitry of this disclosure may determine whether a battery pack has a fault by measuring battery parameters at the positive and negative terminals of the entire battery pack. In some examples, measurement circuit 116 and coulomb counter 114 may not need to measure each individual battery cell of the battery pack to determine whether there is a fault. In other examples, a battery management circuit may be configured to measure each individual cell of a multiple cell battery pack, which may increase complexity and cost of the measurement circuit. In some examples, the techniques of this disclosure may have advantages over other techniques by using connections to the battery pack as a whole, rather than to individual cells of the battery pack.

To avoid false positive fault detection, the circuitry of this disclosure may verify the detected fault and verify the parameters of the charging cycle before reducing the charging current. In some examples, battery management circuitry 110, and/or processing circuitry 102, may compare one or more battery parameters to a threshold value at the beginning of a charge cycle. As one example, processing circuitry 102 may determine whether a state of charge for the battery satisfies a threshold state of charge and determine whether a full charge capacity for the battery satisfies a threshold charge capacity. Then, responsive to determining that both the full charge capacity satisfies the threshold charge capacity and that state of charge of the battery satisfies the threshold state of charge processing circuitry 102, or processing circuitry of battery management circuitry 110, may determine that a battery cell error occurred.

If the one or more battery parameters satisfies the threshold, processing circuitry 102 may determine there is a possible error and store the detected error, for example, at memory 103. To verify the parameters and avoid a false failure, if processing circuitry 102 detects an error in the next subsequent charging cycle, the processing circuitry 102 may then output an indication of a battery fault, as well as may take other action, such as to reduce the charging current.

Each battery cell in a battery pack may have a rated maximum charge current. Exceeding the maximum charge current for a battery cell may damage the cell, and in some examples, may cause damage to areas near the cell, e.g., from overheating. A battery cell of the parallel battery cells may fail or become disconnected during operation, for example, caused by dropping mobile computing device 120, vibration and so on. The charge current to the remaining battery cells of the battery pack, e.g., battery 104, may exceed maximum rated charge current if the charge current is not reduced in the event one of the battery cells is disconnected. By comparing the one or more battery parameters to a threshold value, such as at the beginning of a charge cycle, the circuitry may detect an error, which may be caused by one of the battery cells becoming disconnected. Detecting a similar error in the next subsequent cycle may be an indication that a single fault caused one or more of the other cells to become electrically disconnected. The circuitry may adjust the charge rate such that the charge rate does not exceed the maximum charge rate of any single cell of the battery pack. In some examples, processing circuitry 102 may cause battery management circuitry 110 to reduce the charge rate from charging circuitry 112 to battery 104. In other examples, processing circuitry 102 may cause charging circuitry 112 to shut off the charge current to battery 104 to ensure that the charge rate does not exceed the maximum charge rate of any single cell. In other words, reducing the charge rate may include setting the charge rate to zero, e.g., the magnitude of the charging current is zero, or approximately zero within measurement tolerances.

As noted above, any of the functions attributed to processing circuitry 102 may also be carried out by processing circuitry of battery management circuitry 110, in examples in which battery management circuitry 110 includes processing circuitry. The described functions may also be shared between processing circuitry 102 and any processing circuitry of battery management circuitry 110 executing instructions stored at a computer-readable medium.

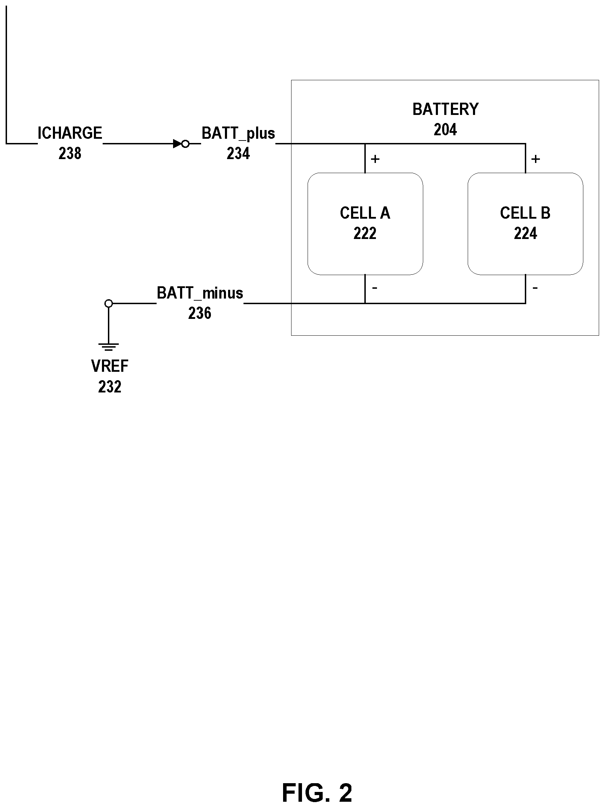

FIG. 2 is a block diagram illustrating an example battery pack with a single cell in series and two cells in parallel. Battery 204 is an example of battery 104 described above in relation to FIG. 1 and may have the same functions and characteristics.

Battery 204 is arranged in a 1S2P configuration, e.g., each cell in series between the positive terminal batt_plus 234 and negative terminal batt_minus 236 and two cells, cell A 222 and cell B 224 in parallel. The open circuit voltage between batt_plus 234 and batt minus 236 is approximately the same as the open circuit voltage for each of cell A 222 and cell B 224. The capacity of battery 204 is the combined capacity of both of cell A 222 and of cell B 224.

In the example of FIG. 2, batt minus 236 connects to a reference voltage Vref 232, which may be the same as a circuit ground. Charging current iCHARGE 238 enters battery 204 at batt_plus 234.

The magnitude of charging current iCHARGE 238 is the charge rate, which may be set and regulated by charging circuitry 112 described above in relation to FIG. 1. In the event that cell B 224 becomes disconnected, or otherwise fails, iCHARGE 238 would all go to cell A 222, instead of being shared between cell A 222 and cell B 224.

In examples where cell B 224 becomes disconnected or otherwise fails, all of iCHARGE 238 is directed to a single cell, e.g., cell A 222. In such examples, battery management circuitry 110 may detect that battery 204 is charging faster than expected. In some examples, when cell B 224 is disconnected, the battery voltage of battery 204 may be just based on cell A 222 and may increase twice as fast as when cell B 224 was connected. Similarly, the charge time of battery 204 may be faster than expected, e.g., twice as fast. In other words, battery 204 may charge in approximately half the expected time. Also, coulomb counter 114 and/or measurement circuit 116 may detect that the change in SOC is faster than expected. That is, the state of charge rate may increase, for example, approximately twice as fast as expected. In some examples, battery management circuitry 110 may be configured to detect that one of the cells of battery 204 is disconnected based on any one or more of a shorter than expected charge time, a faster rate of change of the battery voltage than expected, or the SOC rate change is faster than expected. Battery management circuitry 110 may determine that a cell became disconnected based on measurements taken only from batt_plus 234 and batt minus 236.

Battery management circuitry 110, described above in relation to FIG. 1, may be configured to ensure that the magnitude of iCHARGE 238 is no more than the maximum rated charging current for just cell A 222 or cell B 224 alone in the event of a detected cell fault, as described above in relation to FIG. 1. In some examples, charging circuitry 112 may set the charge rate for battery 204 to zero to make sure that the charge rate does not exceed a maximum charge rate of any single cell of the battery. As described above in relation to FIG. 1, mobile computing device 120 may verify a detected battery error, for example, by checking for a second battery error in a subsequent charging cycle.

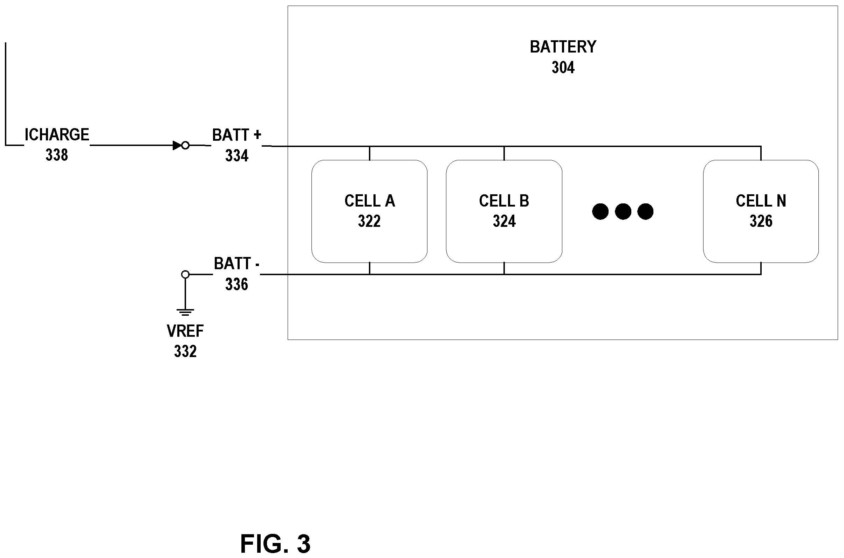

FIG. 3 is a block diagram illustrating an example battery pack with a single cell in series and multiple cells in parallel. Battery 304 is an example of battery 104 and battery 204 described above in relation to FIGS. 1 and 2 and may have the same functions and characteristics.

Battery 304 is arranged in a 1SNP configuration, e.g., each cell is in series between the positive terminal batt_plus 334 and negative terminal batt_minus 336 and N cells, cell A 322, cell B 324 through cell N 326 in parallel. The open circuit voltage between batt_plus 334 and batt minus 336 is approximately the same as the open circuit voltage for each of cell A 322 through cell N 326. The capacity of battery 304 is the combined capacity cell A 322 through cell N 326.

In the example of FIG. 3, batt minus 336 connects to a reference voltage Vref 332, which may be connected to a circuit ground. Charging current iCHARGE 338 enters battery 303 at batt_plus 334. Similar to battery 104 and battery 204 described above in relation to FIGS. 1 and 2, in the event that one or more of the cells of battery 304 fail or are disconnected, iCHARGE 338 may be shared between fewer battery cells, which may exceed the maximum rated charging current for the cell. Therefore, battery management circuitry 110, described above in relation to FIG. 1, may be configured to adjust the magnitude of iCHARGE 338 such that iCHARGE 338 is no more than the maximum rated charging current for just a single cell of battery 304 in the event of a detected cell fault, as described above in relation to FIG. 1.

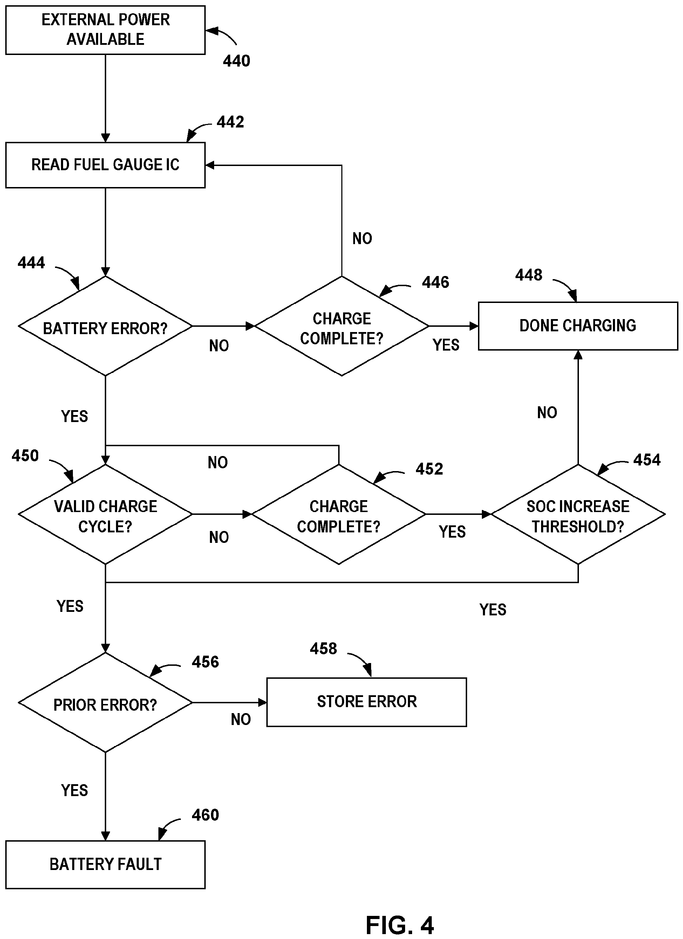

FIG. 4 is a flowchart illustrating an example operation of the battery fault detection techniques of this disclosure. The blocks of FIG. 4 will be described in terms of FIG. 1, unless otherwise noted.

Processing circuitry of mobile computing device 102 may receive an indication of whether external power is available (440), for example whether the charging control circuit, e.g., charging circuitry 112 is connected to an external power source, e.g., external power supply 121 and external power supply 121 is providing electrical energy. Responsive to determining the charging control circuit is connected to, and receiving power from, external power supply 121, the processing circuitry may initiate a charging cycle for battery 104.

The processing circuitry, e.g., processing circuitry 102, may read the fuel gauge IC (442), e.g., battery management circuitry 110, to determine the state of charge, the full charge capacity, and other indications of that state of battery 104. In some examples, battery management circuitry 110 may determine the state of charge of the battery based, at least in part, on discharge behavior of battery 104 when the charging control circuit is disconnected from external power supply 121. For example, battery management circuitry 110 may monitor discharge current, information from coulomb counter 114 and the battery voltage while battery 104 provides power to the components of mobile computing device 120, e.g., load 106.

In some examples, e.g., early in the life of battery 104, the calculated full charge capacity may be near 100%. As the battery ages, or in some examples, with changes in temperature, the battery full charge capacity may decrease. Battery age may be determined based on, for example, the amount of time since the battery was manufactured. In some examples, battery age may also be based on the number of charge and discharge cycles for the battery. In some examples and depending on battery chemistry, battery useful life may be extended by not fully charging the battery during a charging cycle.

Processing circuitry of battery management circuitry 110, and/or processing circuitry 102, may determine whether the full charge capacity for battery 104 satisfies a threshold charge capacity. Some examples of threshold charge capacity may include fifty percent, sixty percent, sixty-five percent, seventy-five percent, or some other value based on the battery characteristics, and the functions of mobile computing device 120. The processing circuitry may also determine whether a state of charge for the battery satisfies a threshold state of charge, for example a state of charge less than ten percent, two percent, or some similar threshold value. The processing circuitry may determine whether there is battery cell error with battery 104 based on determining that both the full charge capacity satisfies the threshold charge capacity and that state of charge of the battery satisfies the threshold state of charge (444).

If both the full charge capacity fails to satisfy the threshold charge capacity and the state of charge of the battery fails to satisfy the threshold state of charge (NO branch of 444), battery management circuitry 110 may continue to charge battery 104 until the charge is complete (YES branch of 446). In some examples, processing circuitry may continue to check for battery error during the charge cycle (NO branch of 446) based on information from, for example, coulomb counter 114 and measurement circuit 116 of battery management circuitry 110. A "charge complete" 446 may be triggered by either battery management circuitry 110 determining that the battery is fully charged, or by disconnecting, or shutting off, external power supply 121. In other words, a full charge, or removing external power may end the charge cycle and be done charging (448). In some examples, when the processing circuitry receives an indication of a completed charge cycle (448) and not detecting an error, the processing circuitry may delete indications of an error from previous charging cycles from memory 103. In other words, responsive to not detecting the battery cell error, processing circuitry 102 may clear any indications of the error from memory 103 as part of the steps of block 448.

If both the full charge capacity satisfies the threshold charge capacity and the state of charge of the battery satisfies the threshold state of charge (YES branch of 444), battery management circuitry 110 may continue to charge battery 104 and may check whether the charge cycle may have provided enough electrical energy to battery 104 to be usable to detect a battery error (450). For example, a short charge cycle, e.g., external power supply 121 provided electrical power for only a short time and therefore charging circuitry 112 only provided a small amount of electrical energy to battery 104, then the charge cycle may not be utilizable to accurately determine that a battery error has occurred.

Therefore, the processing circuitry may determine whether the charging cycle is a usable or valid charging cycle (450), based on whether the SOC of the battery was no more than first SOC threshold at a start of the charging cycle, and the change in SOC of the battery exceeded a second SOC threshold at an end of the charging cycle. In other words, to determine if a charging cycle delivered enough electrical energy to battery 104, the state of charge of battery 104 should be less than a predetermined threshold when a charging cycle starts. Also, the state of charge of battery 104 should increase by a predetermined threshold amount during the same charging cycle.

Responsive to determining that the charging cycle is not a valid charge cycle (NO branch of 450), battery management circuitry 110 may continue to charge battery 104 until the charge is complete (YES branch of 452). In some examples, the processing circuitry may continue to check whether the charging cycle delivered enough energy to battery 104 to be considered a valid charging cycle (NO branch of 452).

Responsive to determining that the charging cycle is a valid charge cycle (YES branch of 450), processing circuitry 102 may check memory 103 for an indication of a prior error in a previous charging cycle (456). If memory 103 does not have a previously stored error (NO branch of 456), then processing circuitry 102 may store the detected error for the current cycle at memory 103 (458).

Also, as described above in relation to FIG. 2, battery management circuitry 110 may be configured to detect that one of the cells of the battery is disconnected based on any one or more of a shorter than expected charge time, a faster rate of change of the battery voltage than expected, or the SOC rate change is faster than expected (454). For the 1S2P arrangement of battery 204, the rate of change may double compared to when battery 204 is functioning normally. For the multi-cell arrangement of battery 304, the rate of change difference from normal may depend on how many total battery cells are in battery 304 and how many cells become disconnected. In other words, battery management circuitry 110 may detect a disconnected cell based on whether any of a change in battery voltage is greater than a threshold voltage change within a first predetermined time period, the SOC rate of the battery satisfies a SOC rate threshold within a second predetermined time period; or the charge time for charging cycle is less than a threshold charge time (454). In some examples the time periods may be approximately equal, and in other examples, each time period may be different. In this disclosure, "approximately equal" means the values are the same for practical purposes, e.g., within manufacturing and measurement tolerances.

If none of rate of change of battery voltage is greater than a threshold voltage change, the SOC rate of the battery satisfies a SOC rate threshold, or the charge time for charging cycle is less than a threshold charge time (NO branch of 454), then the charge cycle may be done (448). In some examples, without a valid charge cycle (NO branch of 450), even though battery management circuitry 110 may have determined that an error has occurred (YES branch of 444), the processing circuitry may also clear any indication of an error in a prior cycle from memory as part of the steps of the done charging block (448).

In other examples, if any one or more of a shorter than expected charge time, a faster rate of change of the battery voltage than expected, or the SOC rate change is faster than expected (YES branch of 454), the processing circuitry may check for a prior error (456). As discussed above, with no indication of a prior error (NO branch of 456), the processing circuitry may store the error at a memory location.

In some examples, the processing circuitry may execute instructions such that a prior error must be in the immediately previous charging cycle before determining that there is a prior error (YES branch of 456). In other words, battery management circuitry 110 may detect an error in two charging cycles in a row before determining that a prior error is stored in memory. Said another way, to verify the parameters and avoid a false failure, if processing circuitry 102 detects an error in the next subsequent charging cycle (YES branch of 456), processing circuitry 102 may then output an indication of a battery fault (460), as well as may take other action, such as to reduce the charging current. In this manner, by reducing, or stopping, the charging current, processing circuitry 102 may ensure that a charge rate for battery 104 does not exceed a maximum charge rate of any single cell of battery 104.

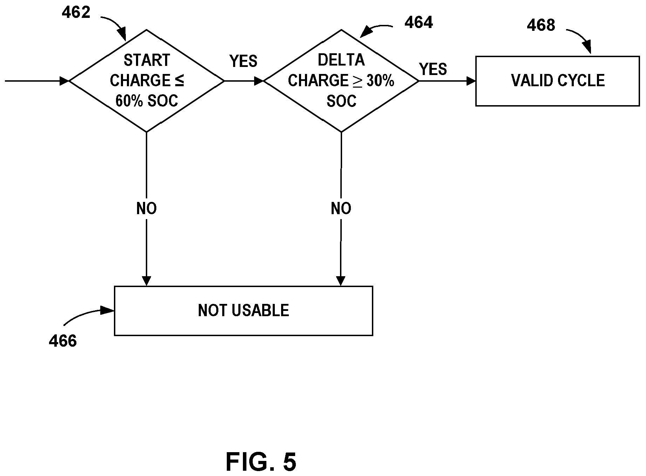

FIG. 5 is a flow chart illustrating an example cycle usability check according to one or more techniques of this disclosure. The blocks of FIG. 5 may correspond to the steps of block 450 described above in relation to FIG. 4 and describe one example of a test for whether the charge cycle may have provided enough electrical energy to battery 104 to be usable to detect a battery error.

Processing circuitry 102, described above in relation to FIG.1, may determine whether the state of charge of the battery was no more than first SOC threshold at the start of the charging cycle (462). In the example of FIG. 5, if the SOC is more than 60% SOC at the start of the charge cycle (NO branch of 462), then the charge cycle is not usable to detect a battery error (466).

If the SOC of battery 104 is less than 60% SOC at the start of the charge cycle (YES branch of 462), then processing circuitry 102 may check whether the change in SOC of the battery exceeded a second SOC threshold by the end of the charging cycle. In the example of FIG. 5, if the change in SOC is less than 30% (NO branch of 464), then the charge cycle is not usable to detect a battery error (466). If the change in SOC is at least 30% (YES branch of 464), then the charge cycle may be considered a valid charge cycle (468) and utilizable to detect a battery error.

The arrangement of blocks 462 and 464 in the example of FIG. 5 is just one example arrangement. Blocks 462 and 464 may be performed in either order as one example technique to whether the charge cycle may have provided enough electrical energy to battery 104 to be usable to detect a battery error. Also, the 60% for the first SOC threshold and 30% for the second SOC threshold in the example of FIG. 5 are also just examples to simplify the description. As described above in relation to FIG. 4, other threshold values may be substituted for the 60% and 30% described in the example of FIG. 5 and may depend on battery chemistry, battery capacity, measurement circuitry and other factors. For example, the first SOC threshold may be in the 20% to 80% range and the second SOC threshold may be 20% to 30% or higher.

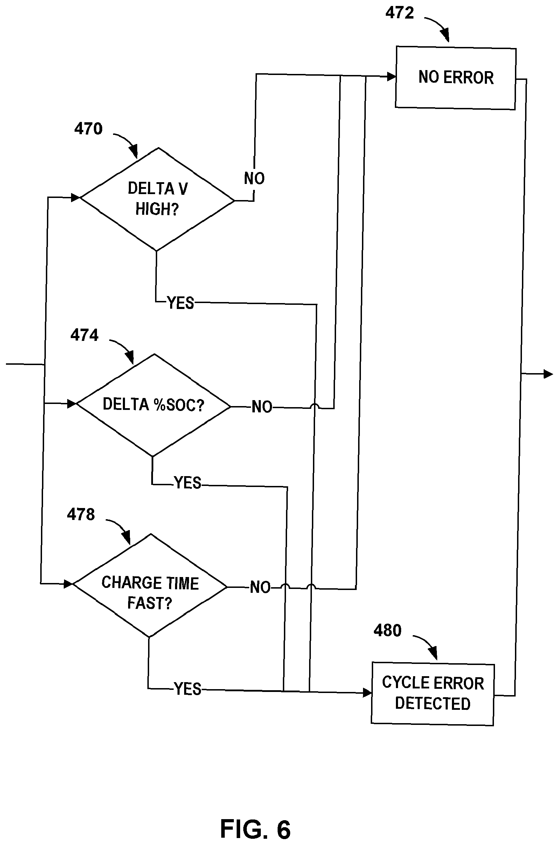

FIG. 6 is a flow chart illustrating an example cycle error check, according to one or more techniques of this disclosure. The blocks of FIG. 6 may correspond to one possible implementation of block 454 described above in relation to FIG. 4. In this disclosure, a "cycle error" may refer to any battery related error during the current charge cycle, e.g., the "battery error" or "cycle error" described above in relation to FIG. 5.

As described above in relation to FIG. 2, should at least one cell of a multi-cell battery pack become disconnected, the charge current, e.g., iCHARGE 238, may charge fewer cells at a faster rate than if no cells become disconnected. In other words, if any one or more of a shorter than expected charge time, a faster rate of change of the battery voltage than expected, or the SOC rate change is faster than expected, then one or more cells of the multi-cell battery may be disconnected.

In the example of FIG. 6, if battery management circuitry 110, described above in relation to FIG. 1, detects that the change in battery voltage over a predetermined time period is higher than expected, e.g., ΔV of the battery is greater than a threshold voltage change (YES branch of 470), then the processing circuitry may determine that there is a cycle error for that charging cycle (480). Similarly, if battery management circuitry 110 detects that change rate of the state of charge, e.g., as measured by the coulomb counter, is higher than expected (Δ%SOC - YES branch of 474), then the processing circuitry may determine that there is a cycle error (480). In other words, when the circuitry detects that the SOC rate of the battery satisfies a SOC rate threshold within a second predetermined time period, one of the battery cells may have become disconnected causing a cycle error (480).

Likewise, if battery management circuitry 110 detects that the charge time for charging cycle is less than a threshold charge time, in other words, the charge time is too fast (YES branch of 478), then the processing circuitry may determine that there is a cycle error (480). If the ΔV of the battery is less than a threshold voltage change (NO branch of 470), the Δ%SOC is within expected limits (NO branch of 474), and the charge time is with expected limits (NO branch of 478), then the processing circuitry may determine that there is no error detected for the charging cycle (472). As noted above, in some examples, the first, second and third predetermined time periods may be approximately the same. In other examples, the first, second and third predetermined time periods may be different from each other.

In one or more examples, the functions described above may be implemented in hardware, software, firmware, or any combination thereof. For example, the various components of FIG. 1, such as processing circuit 102 and battery management circuitry 110 may be implemented in hardware, software, firmware, or any combination thereof. If implemented in software, the functions may be stored on or transmitted over, as one or more instructions or code, a computer-readable medium and executed by a hardware-based processing unit. Computer-readable media may include computer-readable storage media, which corresponds to a tangible medium such as data storage media, or communication media including any medium that facilitates transfer of a computer program from one place to another, e.g., according to a communication protocol. In this manner, computer-readable media generally may correspond to (1) tangible computer-readable storage media which is non-transitory or (2) a communication medium such as a signal or carrier wave.

Data storage media may be any available media that can be accessed by one or more computers or one or more processors to retrieve instructions, code and/or data structures for implementation of the techniques described in this disclosure. A computer program product may include a computer-readable medium. The term "non-transitory" may indicate that the storage medium is not embodied in a carrier wave or a propagated signal. In certain examples, a non-transitory storage medium may store data that can, over time, change (e.g., in RAM or cache).

By way of example, and not limitation, such computer-readable storage media, may include random access memory (RAM), read only memory (ROM), programmable read only memory (PROM), erasable programmable read only memory (EPROM), electronically erasable programmable read only memory (EEPROM), flash memory, a hard disk, a compact disc ROM (CD-ROM), a floppy disk, a cassette, magnetic media, optical media, or other computer readable media. In some examples, an article of manufacture may include one or more computer-readable storage media.

Also, any connection is properly termed a computer-readable medium. For example, if instructions are transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. It should be understood, however, that computer-readable storage media and data storage media do not include connections, carrier waves, signals, or other transient media, but are instead directed to non-transient, tangible storage media. Combinations of the above should also be included within the scope of computer-readable media.

Instructions may be executed by one or more processors, such as one or more DSPs, general purpose microprocessors, ASICs, FPGAs, or other equivalent integrated or discrete logic circuitry. Accordingly, the term "processor," as used herein, such as processing circuitry 102, may refer to any of the foregoing structures or any other structure suitable for implementation of the techniques described herein. Also, the techniques could be fully implemented in one or more circuits or logic elements.

The techniques of this disclosure may be implemented in a wide variety of devices or apparatuses, including, an integrated circuit (IC) or a set of ICs (e.g., a chip set). Various components, modules, or units are described in this disclosure to emphasize functional aspects of devices configured to perform the disclosed techniques, but do not necessarily require realization by different hardware units. Rather, as described above, various units may be combined in a hardware unit or provided by a collection of interoperative hardware units, including one or more processors as described above, in conjunction with suitable software and/or firmware.

The techniques of this disclosure may also be described in the following examples:
Example 1: Example 1: A method comprising: receiving, by processing circuitry, an indication of whether a charging control circuit is connected to an external power source; responsive to determining the charging control circuit is connected to the external power source, initiating, by the processing circuitry, a charging cycle for a battery that includes at least two cells in parallel; determining whether a state of charge for the battery satisfies a threshold state of charge; determining whether a full charge capacity for the battery satisfies a threshold charge capacity; and responsive to determining that both the full charge capacity satisfies the threshold charge capacity and that state of charge of the battery satisfies the threshold state of charge: determining that a battery cell error occurred; and adjusting, by the processing circuitry, a charge rate for the battery such that the charge rate does not exceed a maximum charge rate of any single cell of the battery.
Example 2: The method of example 1, further comprising, responsive to determining the charging control circuit is connected to the external power source, detecting, by the processing circuitry, a cycle error for the charging cycle based on any of: a change in battery voltage being greater than a threshold voltage change within a first predetermined time period; a state of charge rate of the battery satisfying a state of charge rate threshold within a second predetermined time period; or a charge time for the charging cycle being less than a threshold charge time.
Example 3: The method of any of examples 1 and 2, further comprising: determining whether the charging cycle is a valid charging cycle, based on: the state of charge of the battery being no more than first state of charge threshold at a start of the charging cycle; and the change in state of charge of the battery having exceeded a second state of charge threshold at an end of the charging cycle; and responsive to determining the charging cycle is a valid charge cycle, storing an indication of a cycle error at a memory.
Example 4: The method of any combination of examples 1 through 3, further comprising: responsive to determining that the battery cell error occurred, determining, by the processing circuitry whether a previous battery cell error was stored in a memory; and responsive to determining that the previous battery cell error was stored in memory and that the battery cell error occurred, outputting an indication of a battery fault.
Example 5: The method of any combination of examples 1 through 4, further comprising: responsive to determining that the battery cell error occurred, storing an indication of the battery cell error at a memory.
Example 6: The method of any combination of examples 1 through 5, further comprising, responsive to determining that the battery cell error did not occur, clearing any indications of the error from a memory.
Example 7: The method of any combination of examples 1 through 6, wherein adjusting the charge rate for the battery comprises setting the charge rate to zero.
Example 8: A device comprising a rechargeable battery comprising at least two cells in parallel; battery management circuitry configured to control an electrical current flow of the battery; a memory; and processing circuitry operatively coupled to the memory and to the battery management circuitry, the processing circuitry configured to: receive, from the battery management circuitry, an indication that the battery management circuitry is connected to an external power source; responsive to receiving the indication that the battery management circuitry is connected to the external power source, cause the battery management circuit to initiate a charging cycle for the battery; determine whether a state of charge for the battery satisfies a threshold state of charge; determine whether a full charge capacity for the battery satisfies a threshold charge capacity; and responsive to determining that both the full charge capacity satisfies the threshold charge capacity and that state of charge of the battery satisfies the threshold state of charge: determine that a battery cell error occurred; and cause the battery management circuitry to adjust a charge rate for the battery such that the charge rate does not exceed a maximum charge rate of any single cell of the battery.
Example 9: The device of example 8, wherein the processing circuitry is further configured to: responsive to determining the charging control circuit is connected to the external power source, detect a cycle error for the charging cycle based on any of: a change in battery voltage being greater than a threshold voltage change within a first predetermined time period; a state of charge rate of the battery satisfying a state of charge rate threshold within a second predetermined time period; or a charge time for the charging cycle being less than a threshold charge time.
Example 10: The device of any of examples 8 and 9, wherein the processing circuitry is further configured to: determine whether the charging cycle is a valid charging cycle, based on: the state of charge of the battery being no more than first state of charge threshold at a start of the charging cycle; and the change in state of charge of the battery having exceeded a second state of charge threshold at an end of the charging cycle; and responsive to determining the charging cycle is a valid charge cycle, store an indication of a cycle error at a memory.
Example 11 The device of any combination of examples 8 through 10, wherein the processing circuitry is further configured to: responsive to determining that the battery cell error occurred, determine whether a previous battery cell error was stored in memory, and responsive to determining that the previous battery cell error was stored in memory and that the battery cell error occurred, output an indication of a battery fault.
Example 12: The device of any combination of examples 8 through 11, wherein the processing circuitry is further configured to: responsive to determining that the battery cell error occurred, store an indication of the battery cell error at a memory.
Example 13: The device of any combination of examples 8 through 12, wherein the processing circuitry is further configured to: responsive to determining that the battery cell error did not occur, clear any indications of the error from the memory.
Example 14: The device of any combination of examples 8 through 13, wherein to adjust the charge rate for the battery that does not exceed a maximum charge rate of any single cell of the battery comprises setting the charge rate to zero.
Example 15: The device of any combination of examples 8 through 14, wherein the battery management circuitry determines the state of charge of the battery based on discharge behavior of the battery when the charging control circuit is disconnected from the external power source.
Example 16: A non-transitory computer-readable storage medium comprising instructions that, when executed, cause one or more processors of a computing device to: receive an indication of whether a charging control circuit is connected to an external power source; responsive to determining the charging control circuit is connected to the external power source, initiate a charging cycle for a battery wherein the battery includes at least two cells in parallel; determine whether a state of charge for the battery satisfies a threshold state of charge; determine whether a full charge capacity for the battery satisfies a threshold charge capacity; and responsive to determining that both the full charge capacity satisfies the threshold charge capacity and that state of charge of the battery satisfies the threshold state of charge: determine that a battery cell error occurred; and adjust a charge rate for the battery such that the charge rate does not exceed a maximum charge rate of any single cell of the battery.
Example 17: The non-transitory computer-readable storage medium of example 16, further comprising instructions for causing a programmable processor to: responsive to determining the charging control circuit is connected to the external power source, detect a cycle error for the charging cycle based on whether any of: a change in battery voltage is greater than a threshold voltage change within a first predetermined time period; a state of charge (SOC) rate of the battery satisfies a SOC rate threshold within a second predetermined time period; or a charge time for the charging cycle is less than a threshold charge time.
Example 18: The non-transitory computer-readable storage medium of any combination of examples 16 through example 17, further comprising instructions for causing a programmable processor to: determine whether the charging cycle is a valid charging cycle, based on: the state of charge of the battery being no more than first state of charge threshold at a start of the charging cycle; and the change in state of charge of the battery having exceeded a second state of charge threshold at an end of the charging cycle; and responsive to determining the charging cycle is a valid charge cycle, store an indication of a cycle error at a memory.
Example 19: The non-transitory computer-readable storage medium of any combination of examples 16 through example 18, further comprising instructions for causing a programmable processor to: responsive to determining that a battery cell error occurred, determine whether a previous battery cell error was stored in a memory; and responsive to determining that the previous battery cell error was stored in memory and to determining that the battery cell error occurred, output an indication of a battery fault.
Example 20: The non-transitory computer-readable storage medium of any combination of examples 16 through example 19, wherein to adjust the charge rate for the battery such that the charge rate does not exceed a maximum charge rate of any single cell of the battery comprises setting the charge rate to zero.

Various examples of the disclosure have been described. These and other examples are within the scope of the following claims.

## Claims

1. A method comprising:
receiving, by processing circuitry, an indication of whether a charging control circuit is connected to an external power source;
responsive to determining the charging control circuit is connected to the external power source, initiating, by the processing circuitry, a charging cycle for a battery that includes at least two cells in parallel;
determining whether a state of charge for the battery satisfies a threshold state of charge;
determining whether a full charge capacity for the battery satisfies a threshold charge capacity; and
responsive to determining that both the full charge capacity satisfies the threshold charge capacity and that state of charge of the battery satisfies the threshold state of charge:
determining that a battery cell error occurred; and
adjusting, by the processing circuitry, a charge rate for the battery such that the charge rate does not exceed a maximum charge rate of any single cell of the battery.

2. The method of claim 1, further comprising,
responsive to determining the charging control circuit is connected to the external power source, detecting, by the processing circuitry, a cycle error for the charging cycle based on any of:
a change in battery voltage being greater than a threshold voltage change within a first predetermined time period;
a state of charge rate of the battery satisfying a state of charge rate threshold within a second predetermined time period; or
a charge time for the charging cycle being less than a threshold charge time.

3. The method of claim 1 or 2, further comprising:
determining whether the charging cycle is a valid charging cycle, based on:
the state of charge of the battery being no more than first state of charge threshold at a start of the charging cycle; and
a change in the state of charge of the battery having exceeded a second state of charge threshold at an end of the charging cycle; and
responsive to determining the charging cycle is a valid charge cycle, storing an indication of a cycle error at a memory.

4. The method of any one of claims 1 to 3, further comprising:
responsive to determining that the battery cell error occurred, determining, by the processing circuitry whether a previous battery cell error was stored in a memory; and
responsive to determining that the previous battery cell error was stored in memory and that the battery cell error occurred, outputting an indication of a battery fault.

5. The method of any one of the preceding claims, wherein
the method further comprises responsive to determining that the battery cell error occurred, storing an indication of the battery cell error at a memory, and/or
the method further comprises responsive to determining that the battery cell error did not occur, clearing any indications of the error from a memory and/or
adjusting the charge rate for the battery comprises setting the charge rate to zero.

6. A device comprising:
a rechargeable battery comprising at least two cells in parallel;
battery management circuitry configured to control an electrical current flow of the battery;
a memory; and
processing circuitry operatively coupled to the memory and to the battery management circuitry, the processing circuitry configured to:
receive, from the battery management circuitry, an indication that the battery management circuitry is connected to an external power source;
responsive to receiving the indication that the battery management circuitry is connected to the external power source, cause the battery management circuit to initiate a charging cycle for the battery;
determine whether a state of charge for the battery satisfies a threshold state of charge;
determine whether a full charge capacity for the battery satisfies a threshold charge capacity; and
responsive to determining that both the full charge capacity satisfies the threshold charge capacity and that state of charge of the battery satisfies the threshold state of charge:
determine that a battery cell error occurred; and
cause the battery management circuitry to adjust a charge rate for the battery such that the charge rate does not exceed a maximum charge rate of any single cell of the battery.

7. The device of claim 6, further comprising:
a charging control circuit,
wherein the processing circuitry is further configured to:
responsive to determining the battery management circuit is connected to the external power source, detect a cycle error for the charging cycle based on any of:
a change in battery voltage being greater than a threshold voltage change within a first predetermined time period;
a state of charge rate of the battery satisfying a state of charge rate threshold within a second predetermined time period; or
a charge time for the charging cycle being less than a threshold charge time.

8. The device of claim 6 or 7, wherein the processing circuitry is further configured to:
determine whether the charging cycle is a valid charging cycle, based on:
the state of charge of the battery being no more than first state of charge threshold at a start of the charging cycle; and
a change in the state of charge of the battery having exceeded a second state of charge threshold at an end of the charging cycle; and
responsive to determining the charging cycle is a valid charge cycle, store an indication of a cycle error at a memory.

9. The device of any of claims 6 to 8, wherein the processing circuitry is further configured to:
responsive to determining that the battery cell error occurred, determine whether a previous battery cell error was stored in memory, and
responsive to determining that the previous battery cell error was stored in memory and that the battery cell error occurred, output an indication of a battery fault.

10. The device of any one of claims 6 to 9, wherein
the processing circuitry is further configured to responsive to determining that the battery cell error occurred, store an indication of the battery cell error at a memory, and/or
the processing circuitry is further configured to: responsive to determining that the battery cell error did not occur, clear any indications of the error from the memory, and/or
to adjust the charge rate for the battery such that the charge rate does not exceed a maximum charge rate of any single cell of the battery comprises setting the charge rate to zero.

11. The device of any one of claims 6 to 10, further comprising:
a charging control circuit,
wherein the battery management circuitry determines the state of charge of the battery based on discharge behavior of the battery when the charging control circuit is disconnected from the external power source.

12. A non-transitory computer-readable storage medium comprising instructions that, when executed, cause one or more processors of a computing device to:
receive an indication of whether a charging control circuit is connected to an external power source;
responsive to determining the charging control circuit is connected to the external power source, initiate a charging cycle for a battery wherein the battery includes at least two cells in parallel;
determine whether a state of charge for the battery satisfies a threshold state of charge;
determine whether a full charge capacity for the battery satisfies a threshold charge capacity; and
responsive to determining that both the full charge capacity satisfies the threshold charge capacity and that state of charge of the battery satisfies the threshold state of charge:
determine that a battery cell error occurred; and
adjust a charge rate for the battery such that the charge rate does not exceed a maximum charge rate of any single cell of the battery.

13. The non-transitory computer-readable storage medium of claim 12, further comprising instructions for causing a programmable processor to:
responsive to determining the charging control circuit is connected to the external power source, detect a cycle error for the charging cycle based on whether any of:
a change in battery voltage is greater than a threshold voltage change within a first predetermined time period;
a state of charge (SOC) rate of the battery satisfies a SOC rate threshold within a second predetermined time period; or
a charge time for the charging cycle is less than a threshold charge time.

14. The non-transitory computer-readable storage medium claim 12 or 13, further comprising instructions for causing a programmable processor to:
determine whether the charging cycle is a valid charging cycle, based on:
the state of charge of the battery being no more than first state of charge threshold at a start of the charging cycle; and
a change in the state of charge of the battery having exceeded a second state of charge threshold at an end of the charging cycle; and
responsive to determining the charging cycle is a valid charge cycle, store an indication of a cycle error at a memory.

15. The non-transitory computer-readable storage medium of any one of claims 12 to 14, wherein
the non-transitory computer-readable storage medium further comprises instructions for causing a programmable processor to, responsive to determining that a battery cell error occurred, determine whether a previous battery cell error was stored in a memory; and/or
the non-transitory computer-readable storage medium further comprises instructions for causing a programmable processor to, responsive to determining that the previous battery cell error was stored in memory and to determining that the battery cell error occurred, output an indication of a battery fault; and/or
to adjust the charge rate for the battery such that the charge rate does not exceed a maximum charge rate of any single cell of the battery comprises setting the charge rate to zero.
